# FASCICULE DE BREVET EUROPEEN

(11) **EP 3 523 662 B1**
(45) Date de publication et mention de la délivrance du brevet: **15.02.2023**
(21) Numéro de dépôt: 17780438.2
(22) Date de dépôt: 10.10.2017
(51) Int. Cl.: G01R 13/40, G01R 23/17

(54) **SYSTÈME D'ANALYSE DE SPECTRE D'UN SIGNAL RADIOFRÉQUENCE**
SYSTEM ZUR ANALYSE DES SPEKTRUMS EINES RADIOFREQUENZSIGNALS
SYSTEM FOR ANALYSING THE SPECTRUM OF A RADIOFREQUENCY SIGNAL

(30) Priorité: 10.10.2016 FR 1601462
(43) Date de publication de la demande: 14.08.2019
(73) Titulaire: Thales, 92400 Courbevoie (FR); Centre National de la Recherche Scientifique, 75016 Paris (FR); Université Paris-Saclay, 91190 Gif-sur-Yvette (FR)
(72) Inventeur: BORTOLOTTI, Paolo, 91767 Palaiseau (FR); ANANE, Abdelmadjid, 91767 Palaiseau (FR); CROS, Vincent, 91767 Palaiseau (FR); COLLET, Martin, 91767 Palaiseau (FR); MORVAN, Loïc, 91767 Palaiseau (FR); BERGER, Perrine, 91767 Palaiseau (FR)
(74) Mandataire: Lavoix
(86) Numéro de dépôt international: PCT/EP2017/075818
(87) Numéro de publication internationale: WO 2018/069324

(56) Documents cités:
- FR-A1- 3 027 681
- CHIPAUX M ET AL: "Wide bandwidth instantaneous radio frequency spectrum analyzer based on nitrogen vacancy centers in diamond", APPLIED PHYSICS LETTERS, A I P PUBLISHING LLC, US, vol. 107, no. 23, 7 décembre 2015 (2015-12-07), XP012203138, ISSN: 0003-6951, DOI: 10.1063/1.4936758 [extrait le 1901-01-01]
- HAHN C ET AL: "Measurement of the intrinsic damping constant in individual nanodisks of Y3Fe5O12and Y3Fe5O12|Pt", APPLIED PHYSICS LETTERS, A I P PUBLISHING LLC, US, vol. 104, no. 15, 14 avril 2014 (2014-04-14), XP012184648, ISSN: 0003-6951, DOI: 10.1063/1.4871516 [extrait le 1901-01-01] cité dans la demande

## Description

La présente invention concerne un système d'analyse de spectre d'un signal radiofréquence apte à fonctionner dans une bande de fréquence donnée.

L'invention se situe dans le domaine du traitement de signaux radiofréquence, et en particulier des signaux radiofréquence ou hyperfréquence à très large bande instantanée, typiquement de quelques gigahertz (GHz) à plusieurs dizaines de GHz.

Pour l'analyse de spectre de tels signaux, les solutions les plus avancées sont basées sur la numérisation de tels signaux et leur analyse spectrale numérique. Cependant, la numérisation des signaux hyperfréquence est limitée en performance lorsque la bande de fréquence instantanée des signaux dépasse quelques GHz, à cause de la faible dynamique et des non-linéarités. De plus, une très grande puissance calculatoire est nécessaire (de l'ordre de dizaines de Téra opérations) et un tel processus est par conséquent très consommateur en énergie.

La demande de brevet FR 3 027 681 A1 décrit un système d'analyse d'un signal hyperfréquence par imagerie, comprenant un matériau solide dont au moins une propriété optique est modifiable dans une zone simultanément en présence d'une excitation optique ou électrique et d'un signal hyperfréquence comportant une fréquence de résonance coïncidant avec une fréquence de résonance du matériau solide.

L'article « Wide bandwidth instantaneous radio frequency spectrum analyzer based on nitrogen vacancy centers in diamond » de M. Chipaux et al, publié dans Applied Physics Letters, 2015, décrit l'utilisation de centres azote-lacune (ou centres NV) du diamant pour réaliser une résonance magnétique avec un signal radiofréquence et obtenir une analyse de spectre.

Un but de l'invention est de remédier aux inconvénients de l'état de la technique, en proposant un système d'analyse de spectre en continu qui nécessite une bien moindre puissance calculatoire et qui soit rapide, tout en permettant un traitement des signaux de très large bande de fréquence instantanée.

A cet effet, l'invention propose, selon un premier aspect, un système d'analyse de spectre d'un signal radiofréquence apte à fonctionner dans une bande de fréquence donnée, conforme à la revendication 1.

Avantageusement, le système d'analyse de spectre de l'invention permet de capter les composantes spectrales d'un signal radiofréquence grâce à la modification, en présence de ces composantes spectrales, de l'état de polarisation de la lumière dû aux propriétés magnéto-optiques d'ensembles de nanostructures élémentaires, cette modification étant détectée optiquement et transformée en image du spectre du signal radiofréquence.

Avantageusement, l'analyse de spectre est réalisée sensiblement en temps réel par le dispositif d'acquisition d'images.

De plus, l'analyse de spectre est effectuée sans pré-traitement particulier, donc quasiment sans latence et à température ambiante.

Le système d'analyse de spectre d'un signal radiofréquence selon l'invention peut également présenter une ou plusieurs des caractéristiques des revendications 2 à 15, prises indépendamment ou selon toutes leurs combinaisons techniquement acceptables.

D'autres caractéristiques et avantages de l'invention ressortiront de la description qui en est donnée ci-dessous, à titre indicatif et nullement limitatif, en référence aux figures annexées, parmi lesquelles :
- la figure 1 est une vue schématique d'un système d'analyse de spectre selon un premier mode de réalisation de l'invention ;
- la figure 2 est un exemple schématique de la rotation de la polarisation de la lumière dans un mode de réalisation ;
- la figure 3 est une vue en perspective d'une couche mince nanostructurée dans un premier exemple de réalisation ;
- la figure 4 est une vue en perspective d'une couche mince nanostructurée dans un deuxième exemple de réalisation ;
- la figure 5 illustre schématiquement des fréquences de résonance d'un film nanostructuré en lien avec la géométrie des nanostructures ;
- la figure 6 illustre schématiquement la réponse en fréquence d'une couche nanostructurée de disques de diamètre donné.

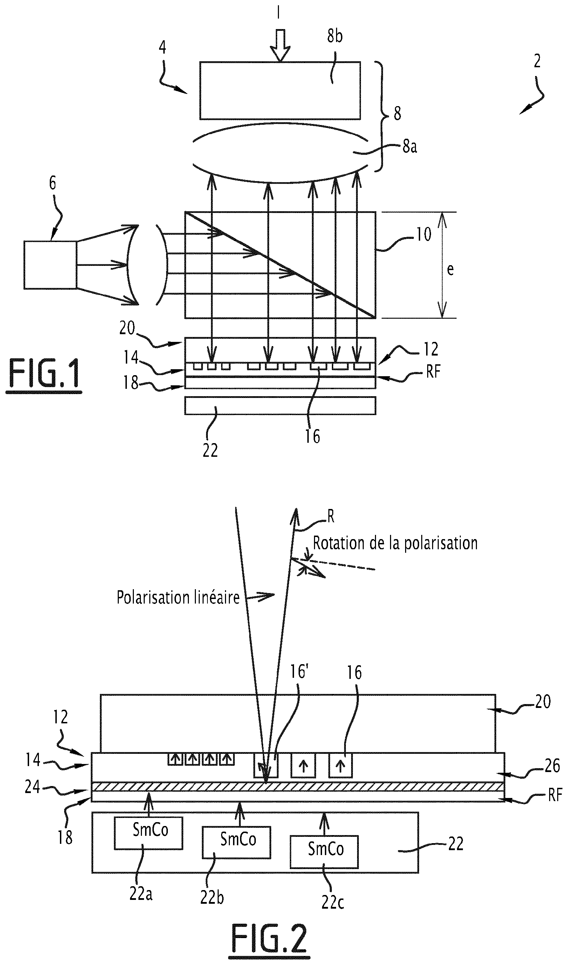

La figure 1 illustre schématiquement un système d'analyse de spectre 2 selon un mode de réalisation de l'invention.

Le système d'analyse de spectre 2 est adapté à analyser le spectre d'un signal radiofréquence dans une bande de fréquence donnée, par exemple de 1GHz à 50GHz, par l'obtention d'une image comportant des informations de puissance spectrale dans la bande considérée.

Comme expliqué en détail ci-après, le système d'analyse de spectre exploite la modification par le signal radiofréquence à analyser de propriétés optiques de structures d'échelle nanométrique ou micrométrique, ces modifications de propriétés optiques étant analysées optiquement et imagées en temps réel par un dispositif d'acquisition d'images approprié.

Le système d'analyse de spectre 2 comprend un système d'illumination et d'acquisition d'images 4, qui comprend une source d'illumination 6 et un dispositif d'acquisition d'images 8.

La source d'illumination 6 est par exemple une source à diode électroluminescente LED ou une source laser, par exemple une diode laser Fabry-Perot.

Le dispositif d'acquisition d'images 8 est positionné de manière à capter la lumière réfléchie par les nanostructures de la couche mince 14, lorsque celle-ci est illuminée par la source d'illumination 6.

Le dispositif d'acquisition d'images 8 est par exemple une caméra, comprenant un système optique 8a et un capteur 8b de type CMOS (pour « complementary metal oxide conductor ») ou CCD (pour « charge coupled device » ou dispositif à transfert de charge).

Le système d'analyse de spectre 2 comprend également un polariseur 10 à séparation de faisceaux, par exemple un prisme de type Glan.

De préférence, le polariseur 10 est un polariseur très sélectif, avec une extinction d'au moins 10⁻⁵.

Dans un mode de réalisation, le polariseur 10 est un double prisme biréfringent Glan-Taylor.

De préférence, l'épaisseur e du polariseur 10 est comprise dans une plage de 0,1 à 10 cm, par exemple de l'ordre de 1 cm.

Le système d'analyse de spectre 2 comporte également un bloc 12 comprenant une couche mince nanostructurée 14, comprenant plusieurs ensembles de nanostructures élémentaires 16, également appelées plots.

La couche mince 14 est en matériau ordonné magnétiquement, de préférence dans la famille des matériaux en grenat d'yttrium et de fer, noté YIG, de formule Y₃Fe₅O₁₂. Avantageusement, ce matériau est transparent et par conséquent facilite la réalisation du dispositif pour réaliser l'interrogation optique.

Selon des variantes, le matériau de la couche mince 14 est dopé avec un ou plusieurs composants pris par exemple dans l'ensemble {Bismuth, Cérium, Lutécium, Praséodyme, Aluminium, Cuivre}, afin d'augmenter l'effet magnéto-optique menant à un changement de l'angle de polarisation de la lumière.

En variante le matériau de la couche mince 14 peut être choisi dans d'autres familles d'oxydes comme par exemple les hexaferrites. Avantageusement le champ d'anisotropie magnétique de cette famille est suffisamment fort pour rendre optionnelle l'utilisation d'un champ magnétique externe. Par exemple, des hexaferrites dopés pour des applications magnéto-optiques sont de type (Ba₁₋ₓ Aₓ)Fe_{12-*y*-*z*}M1*_{y}*M2*_{z}*O₁₉ avec 0≤x≤1, 0≤y≤0.8, 0≤z≤0.8 . Par exemple, l'élément A est choisi dans la liste {Strontium (Sr), Yttrium (Y), Samarium (Sm), Cérium (Ce), Terbium (Tb), Bismuth (Bi), Gandolinium (Gd)} et les éléments M1 et M2 peuvent être choisis parmi la liste {Cobalt (Co), Titane (Ti), Aluminium (AI), Vanadium (V)}.

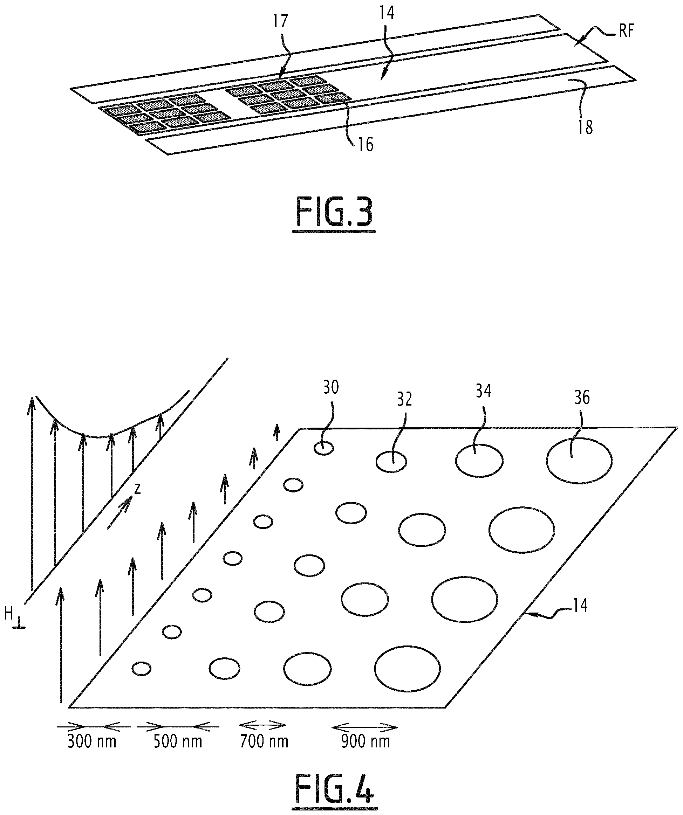

La couche mince nanostructurée 14 est superposée à une couche 18 d'entrée du signal radiofréquence, comprenant une ligne de propagation par exemple une ligne coplanaire comme illustré à la figure 3 et qui a un rôle de guide d'onde permettant de guider le signal radiofréquence RF à analyser vers la couche mince 14.

En variante, une ligne micro-ruban (ou « microstrip » en anglais), ou un autre type de ligne de propagation est utilisé.

Le bloc 12 comprend en outre une couche de substrat 20, transparente et d'épaisseur de l'ordre de 0,5 millimètres.

Par exemple, une couche de substrat en grenat de gadolinium-gallium (GGG) est utilisée. Un tel substrat GGG, éventuellement substitué, est couramment utilisé pour la croissance de films de grenat de fer et d'yttrium par épitaxie.

Le système d'analyse de spectre 2 comprend en outre un bloc 22 de génération de champ magnétique statique.

De préférence, le bloc 22 fournit un champ magnétique statique non uniforme, délivrant un fort gradient spatial allant de 0,1 Tesla à 2 Tesla, dans une direction prédéterminée, sur la partie recouverte par la couche mince nanostructurée 14.

Dans un mode de réalisation, le champ magnétique statique non uniforme est créé par une pluralité d'aimants permanents par exemple en samarium-cobalt (SmCo), positionnés à des distances variables des nanostructures, ces distances variables étant calculées en fonction des aimants utilisés et du gradient spatial souhaité.

Par exemple, un espacement en escalier est appliqué, comme illustré dans l'exemple de réalisation de la figure 2. Plus un aimant SmCo est placé loin de la couche mince nanostructurée, plus le champ magnétique créé est faible.

Le fonctionnement du système d'analyse de spectre 2 est décrit en détail ci-après en référence aux figures 2 à 4.

La couche mince 14 est nanostructurée avec des ensembles de nanostructures élémentaires ou plots, et est soumise au signal radiofréquence RF à analyser, et au champ magnétique statique généré par le bloc 22.

Il est connu de l'homme de métier que de telles nanostructures élémentaires absorbent de l'énergie à leur fréquence propre lorsqu'elles sont soumises à un champ radiofréquence.

La couche mince 14 est nanostructurée avec des ensembles de plots dont la fréquence propre correspond aux canaux fréquentiels à analyser.

Le système d'illumination et d'acquisition d'images 4 permet de sonder optiquement par analyse de polarisation l'état de résonance des ensembles de plots et de former une image contenant l'information de puissance spectrale du signal radiofréquence RF.

En particulier, le dispositif d'acquisition d'images 8 permet d'acquérir une image I, composées de pixels, dont chaque pixel sera représentatif de la puissance d'une fréquence d'intérêt correspondante dans le signal radiofréquence RF.

La figure 2 illustre schématiquement le fonctionnement physique du système d'analyse de spectre de l'invention, dans un mode de réalisation.

Dans le mode de réalisation de la figure 2, le bloc 22 de génération de champ magnétique statique est composé d'aimants permanents 22a, 22b, 22c à des distances variables en escalier du bloc 12 comprenant la couche mince nanostructurée 14.

Dans ce mode de réalisation, une couche miroir 24 est insérée entre la ligne de propagation 18 et la couche nanostructurée 14, permettant d'assurer que les rayons lumineux de la source d'illumination 6 sont bien réfléchis vers le dispositif d'acquisition d'images 8.

En outre, la couche miroir 24 permet de doubler l'effet de rotation.

Les nanostructures 16 de la couche mince 14 sont entourées d'une couche de passivation anti-reflet 26, qui est optionnelle et qui a pour effet de limiter l'éblouissement de la caméra par de la lumière réfléchie non utile.

Plusieurs plots 16 de tailles différentes sont illustrés à la figure 2, chacun étant marqué d'une flèche indiquant la polarisation magnétique associée.

Afin de faciliter l'explication, dans la figure 2, seul le plot 16' entre en résonance sous l'effet du signal radiofréquence RF, ce qui induit une modification de la polarisation magnétique associée et, par conséquent, une rotation de la polarisation d'un rayon lumineux R réfléchi. La modification de la polarisation a pour effet une modification de l'intensité du pixel spatialement correspondant du capteur 8b.

Par conséquent, chaque pixel de l'image I correspondant à une fréquence d'une composante fréquentielle présente dans le signal radiofréquence RF fournira un signal différent de ceux des pixels correspondant à des composantes fréquentielles absentes du signal radiofréquence RF.

Par exemple, dans un mode de réalisation, le réglage de contraste est fait de manière à obtenir des pixels blancs en l'absence d'une composante fréquentielle et des pixels noirs en présence d'une composante fréquentielle.

En variante, une image I en niveaux de gris est obtenue, la valeur de chaque pixel étant représentative de la puissance spectrale à la fréquence associée du signal radiofréquence analysé.

L'image I obtenue permet de représenter le spectre fréquentiel du signal radiofréquence RF analysé.

Dans un mode de réalisation illustré à la figure 3, la couche mince 14 est réalisée par un pavage de nanostructures élémentaires, chaque pavé ou ensemble 17 de nanostructures élémentaires étant associé à un pixel de l'image I formée par le dispositif d'acquisition d'images 8. Les dimensions sont déterminées en fonction de la taille d'un pixel du dispositif d'acquisition d'images.

Par exemple, un pixel correspond à un carré de 100 µm² de la couche mince, et le nombre de nanostructures élémentaires sur chaque carré dépend de leur taille.

De préférence, la densité de nanostructures élémentaires est la plus élevée possible afin que le signal optique détecté soit le plus intense possible.

Dans un mode de réalisation, chaque ensemble 17 de nanostructures élémentaires est formé par un pavage régulier de nanostructures élémentaires.

Un pavage dense et régulier permet de maximiser l'effet optique.

Avantageusement, on obtient une variation de la fréquence de résonance de chaque ensemble de nanostructures 17 en faisant varier la géométrie des nanostructures élémentaires, notamment leur taille, et/ou l'intensité du champ magnétique appliqué, afin d'obtenir une image I représentative du spectre fréquentiel du signal radiofréquence dans divers canaux fréquentiels.

De plus, on peut obtenir une variation de la fréquence de résonance de chaque ensemble de nanostructures par variation locale des composants chimiques des matériaux, par exemple par dopage de certains ensembles de nanostructures.

La figure 4 illustre un mode de réalisation de la couche mince nanostructurée 14 dans laquelle des nanostructures élémentaires en forme de disque de diamètres différents sont agencées par colonnes.

Dans ce mode de réalisation, la couche mince nanostructurée comprend des premières nanostructures élémentaires 30 d'un premier diamètre, par exemple 300 nanomètres (nm), des deuxièmes nanostructures élémentaires 32 d'un deuxième diamètre, par exemple 500 nm, des troisièmes nanostructures élémentaires 34 d'un troisième diamètre, par exemple 700 nm et des quatrièmes nanostructures élémentaires 36 d'un quatrième diamètre, par exemple 900 nm.

Les nanostructures élémentaires 30, 32, 34, 36 sont réparties sur la couche mince 14 de forme rectangulaire, leur nombre par colonne étant différent en fonction de leur diamètre.

L'épaisseur des disques 30, 32, 34, 36 est par exemple égale à 100 nm. De préférence, pour la compatibilité avec la nanostructuration, l'épaisseur des nanostructures est inférieure ou égale à 300 nm.

En variante, les épaisseurs des nanostructures sont variables.

En variante, on peut utiliser des nanostructures de formes géométriques différentes, par exemple des rectangles, des ellipses, des anneaux ou d'autres formes.

Sur la figure 4 est illustrée également la composante orthogonale *H*_{⊥} du champ magnétique généré par le bloc de génération 22, qui est non uniforme, l'intensité diminuant selon l'axe Z.

Grâce à cet agencement, des disques de même taille positionnés à différents endroits spatialement ont des fréquences de résonance différentes, ce qui permet, avantageusement, d'obtenir une image plus précise du spectre fréquentiel d'un signal radiofréquence tout en n'imposant qu'un gradient de champ faible.

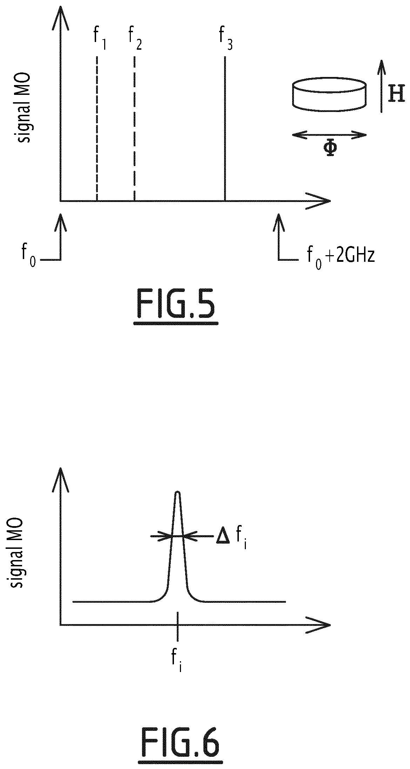

La figure 5 illustre la réponse en fréquence d'un signal magnéto-optique MO, ainsi que des fréquences de résonance f₁, f₂, f₃ différentes pour différents diamètres φ de nanostructures en forme de disque, et pour un champ magnétique H donné.

Des disques de diamètres φ1>φ2>φ3 auront des fréquences de résonance respectives f₁<f₂<f₃. La fréquence f₀ correspond à la fréquence d'un film non structuré.

La figure 6 illustre schématiquement la réponse en fréquence autour d'une fréquence de résonance fᵢ d'une assemblée de disques de diamètre φᵢ donné, la largeur de raie caractéristique étant de Δfᵢ.

La sélectivité en fréquence autour d'une fréquence de résonance a été démontrée dans l'article « Measurement of the intrinsic damping constant in individual nanodisks of YIG and YIG | Pt » de C. Hahn et al, publié dans Applied Physics Letters, 2014.

Par exemple, l'interception d'une plage d'interception d'un canal fréquentiel de 7MHz est réalisée.

On a constaté expérimentalement que pour une épaisseur et un diamètre de disque YIG donnés, une variation d'un Tesla du champ magnétique perpendiculaire appliqué induit un décalage de 28GHz de la fréquence de résonance.

Il est à noter que le dopage du matériau YIG avec du Bismuth ou du Cérium permet d'augmenter la rotation de la polarisation de la lumière, mais induit également un élargissement des raies, la largeur des raies obtenues étant d'environ 80MHz.

Avantageusement, un système d'analyse de spectre 2 tel que décrit ci-dessus en référence à la figure 1, comprenant une diode électroluminescente comme source d'illumination et une caméra CMOS, est peu coûteux et simple à réaliser.

Selon des variantes, la sensibilité du montage est améliorée par l'introduction d'une cavité optique dans laquelle est positionnée la couche mince, permettant de faire circuler la lumière plusieurs fois dans les nanostructures élémentaires et donc d'augmenter la sensibilité.

Par exemple, une cavité optique de faible surtension est réalisée directement sur le substrat 20 par des traitements appropriés.

Selon une autre variante, le système d'analyse de spectre comporte une cavité laser dans laquelle est positionnée la couche mince nanostructurée, par exemple une cavité VCSEL (« vertical cavity surface emitting laser ») ou un laser disque, permettant d'intégrer également la source d'illumination dans le dispositif pour le rendre plus compact. Cette variante permet un grand nombre d'allers-retours du signal optique dans les nanostructures et donc augmente encore la sensibilité.

Selon encore d'autres variantes, il est envisagé de réaliser, au lieu des nanostructures élémentaires, des structures spécifiques, par exemple des réseaux magnoniques (similairement aux réseaux des plasmons ou les cristaux photoniques) permettant d'augmenter le couplage de la lumière avec le matériau des nanostructures.

Le dispositif de l'invention a été décrit ci-dessus avec une seule couche mince 14, mais en variante plusieurs couches minces peuvent être utilisées, par exemple des couches minces superposées en matériaux chimiquement différents et nanostructurées avec des nanostructures décalées spatialement.

Avantageusement, le système d'analyse de spectre permet d'obtenir quasiment sans latence, car nécessitant très peu voire pas de calculs, les composantes spectrales du signal radiofréquence à analyser, sur de large bandes instantanées allant de 1GHz à plus de 50GHz, l'interception se faisant dans des canaux fréquentiels dont la largeur peut être choisie entre 1MHz et 500MHz, la gamme de fréquences et la largeur des canaux fréquentiels interceptées étant sélectionnées par les agencements du dispositif : les choix de matériaux et de géométrie des nanostructures et la variation du gradient spatial du champ magnétique appliqué.

## Revendications

1. Système d'analyse de spectre d'un signal radiofréquence apte à fonctionner dans une bande de fréquence donnée, le système étant apte à fournir une indication de puissance spectrale du signal radiofréquence dans une pluralité de canaux fréquentiels, chaque canal fréquentiel étant défini par une plage de fréquence appartenant à ladite bande de fréquence, comprenant :
- une couche mince (14) en matériau ordonné magnétiquement et soumis au signal radiofréquence (RF) à analyser, ladite couche mince (14) étant nanostructurée et constituée d'une pluralité d'ensembles de nanostructures élémentaires (16), chaque ensemble de nanostructures élémentaires (16) ayant une fréquence de résonance correspondant à un desdits canaux fréquentiels,
et
- un système d'illumination et d'acquisition d'images (4) comportant un dispositif d'acquisition d'images (8), apte à sonder optiquement par analyse de polarisation l'état de résonance des nanostructures élémentaires (16) et à former une image (I) contenant des informations de puissance spectrale du signal radiofréquence (RF) à analyser lorsque ledit signal radiofréquence (RF) atteint ladite couche mince nanostructurée (14),
**caractérisé en ce que**
chaque ensemble de nanostructures élémentaires est formé par un pavage (17) régulier de nanostructures élémentaires, les dimensions dudit pavage (17) étant déterminées en fonction de la taille d'un pixel du dispositif d'acquisition d'images (8).

2. Système d'analyse de spectre selon la revendication 1 **caractérisé en ce qu'**il comporte des nanostructures de géométrie variable permettant d'obtenir une variation de fréquence de résonance.

3. Système d'analyse de spectre selon l'une des revendications 1 ou 2 **caractérisé en ce qu'**une variation de fréquence de résonance est obtenue par application d'un champ magnétique statique non uniforme.

4. Système d'analyse de spectre selon la revendication 3, **caractérisé en ce que** le champ magnétique non uniforme est généré par des aimants permanents (22a, 22b, 22c), au moins deux aimants permanents étant situés à des distances différentes de ladite couche mince (14).

5. Système d'analyse de spectre selon l'une quelconque des revendications 1 à 4, **caractérisé en ce qu'**une variation de fréquence de résonance est obtenue par variation locale des composants chimiques des matériaux.

6. Système d'analyse de spectre selon l'une quelconque des revendications 1 ou 5, **caractérisé en ce qu'**il comporte une ligne de propagation (18) apte à guider le signal radiofréquence (RF) à analyser vers ladite couche mince (14).

7. Système d'analyse de spectre selon la revendication 6, **caractérisé en ce qu'**il comporte une couche miroir (24) positionnée entre la ligne de propagation (18) et ladite couche mince (14).

8. Système d'analyse de spectre selon l'une quelconque des revendications 1 à 7, **caractérisé en ce que** le matériau formant ladite couche mince est un grenat d'yttrium et de fer.

9. Système d'analyse de spectre selon la revendication 8, **caractérisé en ce que** le matériau de la couche mince est dopé avec un ou plusieurs composants pris dans l'ensemble {Bismuth, Cérium, Lutécium, Praséodyme, Aluminium, Cuivre}.

10. Système d'analyse de spectre selon l'une quelconque des revendications 1 à 7, **caractérisé en ce que** le matériau formant ladite couche mince est un hexaferrite.

11. Système d'analyse de spectre selon la revendication 10, dans lequel ledit hexaferrite est de type (Ba₁₋ₓ Aₓ)Fe_{12-*y*-*z*}M1*_{y}*M2*_{z}*O₁₉ avec 0≤x≤1, 0≤y≤0.8, 0≤z≤0.8, avec l'élément A est choisi dans la liste {Strontium, Yttrium, Samarium, Cérium, Terbium, Bismuth, Gandolinium} et les éléments M1 et M2 choisis parmi la liste {Cobalt, Titane, Aluminium, Vanadium}.

12. Système d'analyse de spectre selon l'une des revendications 1 à 11, **caractérisé en ce qu'**il comporte une cavité optique dans laquelle est positionnée au moins ladite couche mince.

13. Système d'analyse de spectre selon l'une des revendications 1 à 11, **caractérisé en ce qu'**il comporte une cavité laser dans laquelle est positionnée au moins ladite couche mince.

14. Système d'analyse de spectre selon l'une quelconque des revendications 1 à 13, **caractérisé en ce que** le dispositif d'acquisition d'images (8) est une caméra CMOS ou une caméra CCD.

15. Système d'analyse de spectre selon l'une quelconque des revendications 1 à 14, **caractérisé en ce que** les nanostructures élémentaires (16) sont en forme de disques ou de rectangles ou d'ellipses ou d'anneaux.

## Patentansprüche

1. System zur Analyse des Spektrums eines Hochfrequenzsignals, das geeignet ist, um in einem gegebenen Frequenzband zu funktionieren, wobei das System eine Angabe der spektralen Leistung des Hochfrequenzsignals in einer Vielzahl von Frequenzkanälen bereitstellen kann, wobei jeder Frequenzkanal durch einen Frequenzbereich definiert ist, der zu dem Frequenzband gehört, umfassend:
- eine dünne Schicht (14) aus magnetisch geordnetem Material, die dem zu analysierenden Hochfrequenzsignal (RF) ausgesetzt ist, wobei die dünne Schicht (14) nanostrukturiert ist und aus einer Vielzahl von Sätzen von elementaren Nanostrukturen (16) besteht, wobei jeder Satz von elementaren Nanostrukturen (16) eine Resonanzfrequenz aufweist, die einem der Frequenzkanäle entspricht,
und
- ein Beleuchtungs- und Bilderfassungssystem (4), umfassend eine Bilderfassungsvorrichtung (8), die geeignet ist, um durch Polarisationsanalyse den Resonanzzustand der elementaren Nanostrukturen (16) optisch zu sondieren und ein Bild (I) zu bilden, das Informationen über die spektrale Leistung des zu analysierenden Hochfrequenzsignals (RF) enthält, wenn das Hochfrequenzsignal (RF) die nanostrukturierte dünne Schicht (14) erreicht, **dadurch gekennzeichnet, dass** jeder Satz von elementaren Nanostrukturen durch eine regelmäßige Pflasterung (17) von elementaren Nanostrukturen gebildet ist, wobei die Abmessungen der Pflasterung (17) abhängig von der Größe eines Pixels der Bilderfassungsvorrichtung (8) bestimmt werden.

2. System zur Spektrumsanalyse nach Anspruch 1, **dadurch gekennzeichnet, dass** es Nanostrukturen mit variabler Geometrie umfasst, die es ermöglichen, eine Variation der Resonanzfrequenz zu erlangen.

3. System zur Spektrumanalyse nach einem der Ansprüche 1 oder 2, **dadurch gekennzeichnet, dass** eine Änderung der Resonanzfrequenz durch Anlegen eines ungleichmäßigen statischen Magnetfelds erlangt wird.

4. System zur Spektrumanalyse nach Anspruch 3, **dadurch gekennzeichnet, dass** das ungleichmäßige Magnetfeld durch Permanentmagnete (22a, 22b, 22c) erzeugt wird, wobei mindestens zwei Permanentmagnete in unterschiedlichen Abständen von der dünnen Schicht (14) angeordnet sind.

5. System zur Spektrumanalyse nach einem der Ansprüche 1 bis 4, **dadurch gekennzeichnet, dass** eine Variation der Resonanzfrequenz durch lokale Variation der chemischen Komponenten der Materialien erlangt wird.

6. System zur Spektrumanalyse nach einem der Ansprüche 1 oder 5, **dadurch gekennzeichnet, dass** es eine Propagationslinie (18) umfasst, die geeignet ist, um das zu analysierende Hochfrequenzsignal (RF) in Richtung der besagten dünnen Schicht (14) zu leiten.

7. System zur Spektrumanalyse nach Anspruch 6, **dadurch gekennzeichnet, dass** es eine Spiegelschicht (24) umfasst, die zwischen der Ausbreitungslinie (18) und der besagten dünnen Schicht (14) positioniert ist.

8. System zur Spektrumanalyse nach einem der Ansprüche 1 bis 7, **dadurch gekennzeichnet, dass** das Material, das die dünne Schicht bildet, ein Yttrium-Eisen-Granat ist.

9. System zur Spektrumanalyse nach Anspruch 8, **dadurch gekennzeichnet, dass** das Material der dünnen Schicht mit einer oder mehreren Komponenten aus der Gruppe {Bismuth, Cer, Lutecium, Praseodym, Aluminium, Kupfer} dotiert ist.

10. System zur Spektrumanalyse nach einem der Ansprüche 1 bis 7, **dadurch gekennzeichnet, dass** das Material, das die dünne Schicht bildet, ein Hexaferrit ist.

11. System zur Spektrumanalyse nach Anspruch 10, wobei der Hexaferrit vom Typ (Ba₁₋ₓ Aₓ)Fe_{12-*y*-*z*}M1*_{y}*M2*_{z}*O₁₉, wobei 0≤x≤1, 0≤y≤0,8, 0≤z≤0,8, wobei das Element A ausgewählt ist aus der Liste {Strontium, Yttrium, Samarium, Cer, Terbium, Wismut, Gandolinium} und die Elemente M1 und M2 ausgewählt sind aus der Liste {Kobalt, Titan, Aluminium, Vanadium}.

12. System zur Spektrumanalyse nach einem der Ansprüche 1 bis 11, **dadurch gekennzeichnet, dass** es einen optischen Hohlraum umfasst, in dem mindestens die besagte dünne Schicht positioniert ist.

13. System zur Spektrumanalyse nach einem der Ansprüche 1 bis 11, **dadurch gekennzeichnet, dass** es einen Laserhohlraum umfasst, in dem mindestens die besagte dünne Schicht positioniert ist.

14. System zur Spektrumanalyse nach einem der Ansprüche 1 bis 13, **dadurch gekennzeichnet, dass** die Bilderfassungsvorrichtung (8) eine CMOS-Kamera oder eine CCD-Kamera ist.

15. System zur Spektrumanalyse nach einem der Ansprüche 1 bis 14, **dadurch gekennzeichnet, dass** die elementaren Nanostrukturen (16) scheibenförmig oder rechteckig oder ellipsenförmig oder ringförmig sind.

## Claims

1. A system for analysing the spectrum of a radio frequency signal capable of operating in a given frequency band, the system being capable of providing an indication of spectral power of the radio frequency signal in a plurality of frequency channels, each frequency channel being defined by a frequency range within said frequency band, comprising:
- a thin layer (14) of magnetically ordered material subjected to the radio frequency (RF) signal to be analysed, said thin layer (14) being nanostructured and consisting of a plurality of sets of elementary nanostructures (16), each set of elementary nanostructures (16) having a resonance frequency corresponding to one of said frequency channels,
and
- an illumination and image acquisition system (4) comprising an image acquisition device (8), capable of optically probing by polarization analysis the resonance state of elementary nanostructures (16) and of forming an image (I) containing spectral power information of the radio frequency (RF) signal to be analysed when said radio frequency (RF) signal reaches said nanostructured thin layer (14), **characterised in that** each set of elementary nanostructures is formed by a regular paving (17) of elementary nanostructures, the dimensions of said paving (17) being determined according to the size of a pixel of the image acquisition device (8).

2. The spectrum analysis system according to claim 1, **characterised in that** it comprises nanostructures of variable geometry making it possible to obtain a variation in resonance frequency.

3. The spectrum analysis system according to any of claims 1 or 2 **characterised in that** a resonant frequency variation is obtained by applying a non-uniform static magnetic field.

4. The spectrum analysis system according to claim 3, **characterised in that** the non-uniform magnetic field is generated by permanent magnets (22a, 22b, 22c), at least two permanent magnets being located at different distances from said thin layer (14).

5. The spectrum analysis system according to any one of claims 1 to 4, **characterised in that** a variation in resonant frequency is obtained by local variation of the chemical components of the materials.

6. The spectrum analysis system according to any one of claims 1 or 5, **characterised in that** it comprises a propagation line (18) capable of guiding the radio frequency (RF) signal to be analysed towards said thin layer (14).

7. The spectrum analysis system according to claim 6, **characterised in that** it comprises a mirror layer (24) positioned between the propagation line (18) and said thin layer (14).

8. The spectrum analysis system according to any one of claims 1 to 7, **characterised in that** the material forming said thin layer is an yttrium and iron garnet.

9. The spectrum analysis system according to claim 8, **characterised in that** the thin layer material is doped with one or more of the components {Bismuth, Cerium, Lutecium, Praseodymium, Aluminium, Copper}.

10. The spectrum analysis system according to any one of claims 1 to 7, **characterised in that** the material forming said thin layer is a hexaferrite.

11. The spectrum analysis system according to claim 10, wherein said hexaferrite is of the type (Ba₁₋ₓ Aₓ)Fe_{12-*y*-*z*}M1*_{y}*M2*_{z}*O₁₉ with 0≤x≤1, 0≤y≤0.8, 0≤z≤0.8, the element A being selected from the list {Strontium, Yttrium, Samarium, Cerium, Terbium, Bismuth, Gandolinium} and the elements M1 and M2 being selected from the list {Cobalt, Titanium, Aluminium, Vanadium}.

12. The spectrum analysis system according to one of claims 1 to 11, **characterised in that** it comprises an optical cavity in which at least said thin layer is positioned.

13. The spectrum analysis system according to one of claims 1 to 11, **characterised in that** it comprises a laser cavity in which at least said thin layer is positioned.

14. The spectrum analysis system according to any one of claims 1 to 13, **characterised in that** the image acquisition device (8) is a CMOS camera or a CCD camera.

15. The spectrum analysis system according to any one of claims 1 to 14, **characterised in that** the elementary nanostructures (16) are disc-shaped or rectangular or elliptical or ring-shaped.
